# EUROPEAN PATENT APPLICATION

(11) **EP 3 951 855 A1**
(43) Date of publication of application: **09.02.2022**
(21) Application number: 20806773.6
(22) Date of filing: 12.05.2020
(51) Int. Cl.: H01L 23/31, H01L 23/367, H01L 21/56

(54) **EMBEDDED PACKAGING STRUCTURE AND PREPARATION METHOD THEREFOR, AND TERMINAL**

(30) Priority: 13.05.2019 CN 201910391845; 07.08.2019 CN 201910727469
(71) Applicant: Huawei Technologies Co., Ltd., Shenzhen, Guangdong 518129 (CN)
(72) Inventor: GUO, Xueping, Shenzhen, Guangdong 518129 (CN); TIAN, Qingshan, Shenzhen, Guangdong 518129 (CN); HAN, Jianhua, Shenzhen, Guangdong 518129 (CN)
(74) Representative: Gill Jennings & Every LLP
(86) International application number: PCT/CN2020/089849
(87) International publication number: WO 2020/228704

(57) **Abstract**

This application provides an embedded package structure and a preparation method therefor, and a terminal. The embedded package structure includes: a first dielectric layer, where the first dielectric layer includes a first surface and a second surface; further includes a first device embedded in the first dielectric layer, where a thermal conductive layer is attached to a surface of the first device that is exposed on the first surface and a first circuit layer is connected to a surface of the first device that is exposed on the second surface; and a second dielectric layer and a third dielectric layer that are symmetrically disposed on two sides of the first dielectric layer. It can be learned from the foregoing description that quasi-symmetrical structures: the second dielectric layer and the third dielectric layer, and the thermal conductive layer and the first circuit layer, are respectively disposed on the two opposite sides of the first dielectric layer, so that the entire embedded package structure forms a quasi-symmetrical structure. In this way, expansion coefficients of the two sides of the first dielectric layer are approximately equal, to alleviate warpage of the embedded package structure. Moreover, the disposed thermal conductive layer and first circuit layer facilitate heat dissipation of the first device.

## Description

This application claims priority to Chinese Patent Application No. 201910391845.0, filed with China National Intellectual Property Administration on May 13, 2019 and entitled "NOVEL EMBEDDED PACKAGE SUBSTRATE STRUCTURE AND PROCESS METHOD", and claims priority to Chinese Patent Application No. 201910727469.8, filed with China National Intellectual Property Administration on August 7, 2019 and entitled "EMBEDDED PACKAGE STRUCTURE AND PREPARATION METHOD THEREFOR, AND TERMINAL", which are incorporated herein by reference in their entireties.

### TECHNICAL FIELD

This application relates to the field of communications technologies, and in particular, to an embedded package structure and a preparation method therefor, and a terminal.

### BACKGROUND

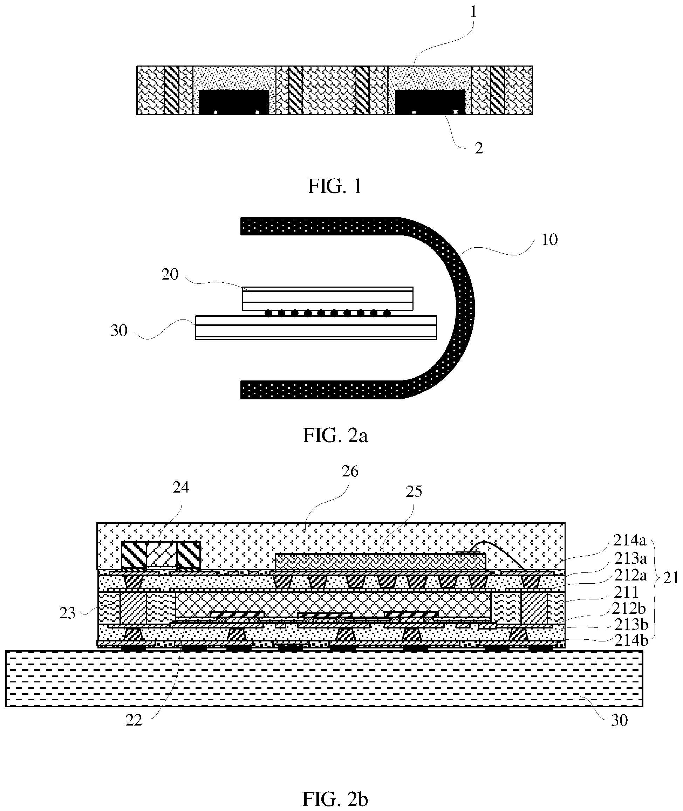

With development of terminal mobile phone products, architectures and functions constantly increase. A growing quantity of functions are integrated into a mainboard of a mobile phone. However, due to a limitation of an appearance size of the mobile phone, internal space of the mobile phone is limited. Therefore, an embedded package technology for integrating devices from a surface of a substrate to the inside of the substrate has prominent advantages in miniaturization and high performance, and has become an application hotspot of the package technology. As shown in FIG. 1, in an embedded package substrate in a conventional technology, a substrate 1 is trenched and then a die 2 is embedded. However, a back surface of the die 2 is wrapped by resin, affecting heat dissipation of the die 2. In addition, when a window opened in an insulation layer of the die 2 and a distance between pads are relatively small, there is no enough space to lead out metal wires interconnecting the die 2 and other devices of a terminal mobile phone to which the die 2 is applied, affecting embedment of the high-density die 2 with a plurality of pins. The die 2 is completely embedded into an organic dielectric layer of the substrate 1. Because thermal conductivity of a dielectric resin material is relatively low, heat consumption of the die 2 cannot be effectively dissipated. In addition, an asymmetric structure of the embedded substrate 1 causes problems in manufacturing and applying the embedded substrate 1.

### SUMMARY

This application provides an embedded package structure and a preparation method therefor, and a terminal, to improve heat dissipation of a chip and alleviate warpage of a substrate.

According to a first aspect, an embedded package structure is provided. The embedded package structure includes: a first dielectric layer, where the first dielectric layer includes a first surface and a second surface that are disposed opposite to each other; further includes a first device embedded in the first dielectric layer, where a difference between a thickness of the first device and a thickness of the first dielectric layer is within a specified range; a thermal conductive layer, disposed on the first surface, where the thermal conductive layer is in contact with the first device; and further includes a first circuit layer, disposed on the second surface of the first dielectric layer, where the first circuit layer is electrically connected to the first device. An expansion coefficient of the thermal conductive layer is the same as that of the first circuit layer. The substrate further includes a second dielectric layer, covering the thermal conductive layer, where at least one thermal hole connected to the thermal conductive layer is provided in the second dielectric layer; and further includes a third dielectric layer, covering the first circuit layer, where a first via connected to the first circuit layer is provided in the third dielectric layer. Moreover, an expansion coefficient of the second dielectric layer is the same as that of the third dielectric layer. It can be learned from the foregoing description that structures of the thermal conductive layer and the first circuit layer that are prepared by using materials with the same expansion coefficient, and the second dielectric layer and the third dielectric layer that are prepared by using materials with the same expansion coefficient are respectively disposed on two opposite sides of the first dielectric layer, so that the entire embedded package structure forms a quasi-symmetrical structure. When the substrate is deformed by heat, an expansion status of the thermal conductive layer is approximate to that of the first circuit layer, and an expansion status of the second dielectric layer is approximate to that of the third dielectric layer, so that warpage of the embedded package structure is alleviated. Moreover, the disposed thermal conductive layer and first circuit layer facilitate heat dissipation of the first device.

In a specific implementation, the first dielectric layer is prepared by using resin doped with no glass fiber, and the second dielectric layer and the third dielectric layer are prepared by using resin doped with glass fiber. Air bubbles generated when the first dielectric layer wraps the first device are reduced.

In a specific implementation, the thickness of the first device is equal to that of the first dielectric layer. In this way, two sides of the first device can be in direct contact with the thermal conductive layer and the first circuit layer. In this application, thicknesses being equal means that if a tolerance between two thicknesses is within a range of ±20 microns, the two thicknesses are considered as the same thickness.

In a specific implementation, a thickness of the second dielectric layer is equal to that of the third dielectric layer, a second circuit layer is disposed on a surface of the third dielectric layer facing away from the first dielectric layer, and the second circuit layer is electrically connected to the first circuit layer through the first via. The second circuit layer is electrically connected to the first circuit layer through the first via. A third circuit layer is disposed on a surface of the second dielectric layer facing away from the first dielectric layer, and the third circuit layer is electrically connected to the first circuit layer. An expansion coefficient of the second circuit layer is the same as that of the third circuit layer. Warpage of the substrate is alleviated by using the second circuit layer and the third circuit layer that have the same expansion coefficient.

In a specific implementation, the first device is a die, and the thermal conductive layer is in direct contact with the die. The die is used, so that the thermal conductive layer can be in direct contact with the die, and a heat dissipation effect is improved compared with that of a packaged chip in a conventional technology.

In a specific implementation, an area in which the thermal conductive layer covers the first surface is greater than an area of a surface that is of the first device and that is exposed on the first device, thereby further improving the heat dissipation effect.

In a specific implementation, the specified range is 0 microns to 50 microns. Specifically, the specified range may include different thicknesses such as 0 microns, 10 microns, 20 microns, 30 microns, 40 microns, and 50 microns.

In a specific implementation, at least one through hole is provided in the first dielectric layer, a conductive pillar is fixed in each through hole, and a second via in one-to-one correspondence with the conductive pillar is provided in the second dielectric layer; a third via in communication with the conductive pillar is provided in the third dielectric layer; and the third circuit layer is connected to the second circuit layer by using the electrically connected second via, conductive pillar, and third via. A conductive connection between circuits is implemented.

In a specific implementation, the embedded package structure further includes a second device disposed at the second dielectric layer and a fourth dielectric layer used for embedding the second device, where the second device is electrically connected to the first circuit layer.

In a specific implementation, the second device is electrically connected to the third circuit layer by using a metal jumper wire and/or a solder ball, and the third circuit layer is electrically connected to the first circuit layer.

According to a second aspect, a terminal is provided. The terminal includes a housing and a mainboard disposed in the housing, and further includes an embedded package structure disposed on the mainboard. The embedded package structure includes a first dielectric layer, where the first dielectric layer includes a first surface and a second surface that are disposed opposite to each other; a first device embedded in the first dielectric layer, where a difference between a thickness of the first device and a thickness of the first dielectric layer is within a specified range; a thermal conductive layer, disposed on the first surface, where the thermal conductive layer is in contact with the first device; a first circuit layer, disposed on the second surface of the first dielectric layer, where the first circuit layer is electrically connected to the first device; a second dielectric layer, covering the thermal conductive layer, where at least one thermal hole connected to the thermal conductive layer is provided in the second dielectric layer; and a third dielectric layer, covering the first circuit layer, where a first via connected to the first circuit layer is provided in the third dielectric layer. It can be learned from the foregoing description that structures of the thermal conductive layer and the first circuit layer that are prepared by using materials with the same expansion coefficient, and the second dielectric layer and the third dielectric layer that are prepared by using materials with the same expansion coefficient are respectively disposed on two opposite sides of the first dielectric layer, so that the entire embedded package structure forms a quasi-symmetrical structure. When a substrate is deformed by heat, an expansion status of the thermal conductive layer is approximate to that of the first circuit layer, and an expansion status of the second dielectric layer is approximate to that of the third dielectric layer, so that warpage of the embedded package structure is alleviated. Moreover, the disposed thermal conductive layer and first circuit layer facilitate heat dissipation of the first device.

In a specific implementation, the first dielectric layer is prepared by using resin doped with no glass fiber, and the second dielectric layer and the third dielectric layer are prepared by using resin doped with glass fiber. Air bubbles generated when the first dielectric layer wraps the first device are reduced.

In a specific implementation, the thickness of the first device is equal to that of the first dielectric layer. In this way, two sides of the first device can be in direct contact with the thermal conductive layer and the first circuit layer.

In a specific implementation, a thickness of the second dielectric layer is equal to that of the third dielectric layer, a second circuit layer is disposed on a surface of the third dielectric layer facing away from the first dielectric layer, and the second circuit layer is electrically connected to the first circuit layer through the first via. The second circuit layer is electrically connected to the first circuit layer through the first via. A third circuit layer is disposed on a surface of the second dielectric layer facing away from the first dielectric layer, and the third circuit layer is electrically connected to the first circuit layer. An expansion coefficient of the second circuit layer is the same as that of the third circuit layer. Warpage of the substrate is alleviated by using the second circuit layer and the third circuit layer that have the same expansion coefficient.

In a specific implementation, the first device is a die, and the thermal conductive layer is in direct contact with the die. The die is used, so that the thermal conductive layer can be in direct contact with the die, and a heat dissipation effect is improved compared with that of a packaged chip in a conventional technology.

In a specific implementation, an area in which the thermal conductive layer covers the first surface is greater than an area of a surface of the first device, thereby further improving the heat dissipation effect.

In a specific implementation, at least one through hole is provided in the first dielectric layer, a conductive pillar is fixed in each through hole, and a second via in one-to-one correspondence with the conductive pillar is provided in the second dielectric layer; a third via in communication with the conductive pillar is provided in the third dielectric layer; and the third circuit layer is connected to the second circuit layer by using the electrically connected second via, conductive pillar, and third via. A conductive connection between circuits is implemented.

In a specific implementation, the embedded package structure further includes a second device disposed at the second dielectric layer, where the second device is electrically connected to the first circuit layer.

In a specific implementation, the second device is electrically connected to the third circuit layer by using a metal jumper wire and/or a solder ball, and the third circuit layer is electrically connected to the first circuit layer.

In a specific implementation, the embedded package structure further includes a fourth dielectric layer used for embedding the second device, to improve safety of the second device.

According to a third aspect, a method for preparing an embedded package structure is provided. The method includes the following steps: preparing a first dielectric layer around a first device, the first device being embedded in the prepared first dielectric layer, two opposite surfaces of the first device being respectively exposed on a first surface and a second surface that are opposite to each other of the first dielectric layer, and a difference between a thickness of the first device and a thickness of the first dielectric layer being within a specified range; attaching a thermal conductive layer to the first surface, where the thermal conductive layer is in contact with the first device; preparing a second dielectric layer at the thermal conductive layer; preparing at least one thermal hole in the second dielectric layer, where the at least one thermal hole connected to the thermal conductive layer is provided in the second dielectric layer; preparing, on the second surface, a first circuit layer connected to the first device; preparing a third dielectric layer at the first circuit layer; and preparing, in the third dielectric layer, a first via connected to the first circuit layer. An expansion coefficient of the thermal conductive layer is the same as that of the first circuit layer, and an expansion coefficient of the second dielectric layer is the same as that of the third dielectric layer. It can be learned from the foregoing description that structures of the thermal conductive layer and the first circuit layer that are prepared by using materials with the same expansion coefficient, and the second dielectric layer and the third dielectric layer that are prepared by using materials with the same expansion coefficient are respectively disposed on two opposite sides of the first dielectric layer, so that the entire embedded package structure forms a quasi-symmetrical structure. When a substrate is deformed by heat, an expansion status of the thermal conductive layer is approximate to that of the first circuit layer, and an expansion status of the second dielectric layer is approximate to that of the third dielectric layer, so that warpage of the embedded package structure is alleviated. Moreover, the disposed thermal conductive layer and first circuit layer facilitate heat dissipation of the first device.

In a specific implementation, the method further includes: preparing a second circuit layer on a surface of the third dielectric layer facing away from the first dielectric layer, where the second circuit layer is electrically connected to the first circuit layer through the first via; preparing a third circuit layer on a surface of the second dielectric layer facing away from the first dielectric layer; and electrically connecting the third circuit layer to the first circuit layer. An expansion coefficient of the second circuit layer is the same as that of the third circuit layer.

In a specific implementation, the preparing a first dielectric layer around a first device, the first device being embedded in the prepared first dielectric layer, two opposite surfaces of the first device being respectively exposed on a first surface and a second surface that are opposite to each other of the first dielectric layer is specifically: disposing a copper foil layer on a carrier board; placing the first device at the copper foil layer; forming a dielectric layer at the copper foil layer through injection molding, to wrap the first device; and thinning the dielectric layer to form the first dielectric layer.

In a specific implementation, the electrically connecting the third circuit layer to the first circuit layer is specifically:
preparing a conductive pillar at the copper foil layer; wrapping, by the dielectric layer, the conductive pillar when the dielectric layer is formed at the copper foil layer through injection molding; the conductive pillar being exposed when the dielectric layer is thinned to form the first dielectric layer; when the second dielectric layer is prepared, providing a second via electrically connected to the conductive pillar; the second circuit layer being electrically connected to the second via when the second circuit layer is disposed; de-bonding the first dielectric layer from the copper foil layer; preparing a third via when the third dielectric layer is prepared, where the third via is electrically connected to the conductive pillar; and electrically connecting the third circuit layer to the third via when the third circuit layer is prepared.

In a specific implementation, an area in which the thermal conductive layer covers the first surface is greater than an area of a surface of the first device.

### BRIEF DESCRIPTION OF DRAWINGS

FIG. 1 is a schematic structural diagram of an embedded package structure in a conventional technology;
FIG. 2a is a schematic structural diagram of a terminal according to an embodiment of this application;
FIG. 2b is a schematic diagram of a connection between a terminal and a mainboard according to an embodiment of this application;
FIG. 3a is a schematic structural diagram of an embedded package structure according to an embodiment of this application;
FIG. 3b is a cutaway drawing along A-A in FIG. 3a;
FIG. 4a is a schematic structural diagram of a substrate according to an embodiment of this application;
FIG. 4b is another schematic structural diagram of a substrate according to an embodiment of this application;
FIG. 5a is a schematic structural diagram of an embedded package structure according to an embodiment of this application;
FIG. 5b is another schematic structural diagram of an embedded package structure according to an embodiment of this application;
FIG. 6 is a schematic diagram of a current path of an embedded package structure according to an embodiment of this application; and
FIG. 7 to FIG. 21 are flowcharts of preparing an embedded package structure according to an embodiment of this application.

### DESCRIPTION OF EMBODIMENTS

First, an application scenario of an embedded package structure is described. The embedded package structure is applied to a mobile terminal, such as a mobile phone, a tablet computer, or a wearable device (such as an electronic watch). As shown in FIG. 2a, using a mobile phone as an example, the mobile terminal includes a housing 10 and a printed circuit board disposed in the housing 10. An embedded package structure 20 is disposed on the printed circuit board. The printed circuit board may be a mainboard 30 of the mobile terminal. During a specific connection, the embedded package structure 20 is electrically connected to the mainboard 30, as shown in FIG. 2a and FIG. 2b. The embedded package structure 20 is placed on the mainboard 30, and may be electrically connected to the mainboard 30 by using a BGA (ball grid array), as shown in FIG. 2a, or electrically connected to the mainboard 30 by using an LGA (land grid array), as shown in FIG. 2b. A first device is embedded in the embedded package structure 20, where the first device may be a chip or a passive device, and the chip may be chips with different functions, for example, a CPU chip, a radio frequency drive chip, or a chip of another processor. When the passive device is used, the passive device may be a capacitor, an inductor, or a resistor.

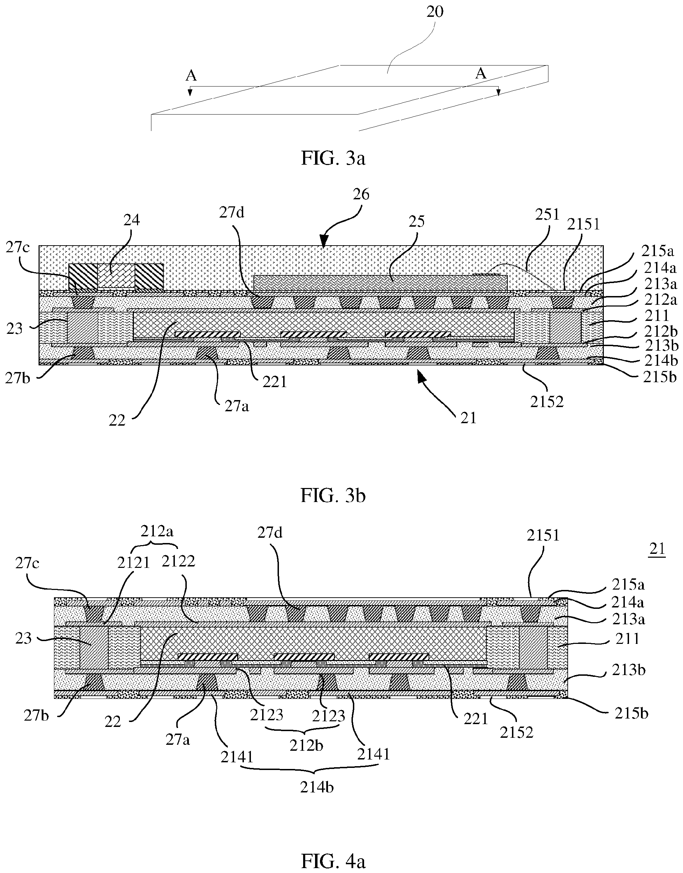

To facilitate understanding of the embedded package structure 20 provided in this embodiment of this application, the following describes a specific structure of the embedded package structure 20 with reference to the accompanying drawings. First refer to FIG. 3a and FIG. 3b. FIG. 3a shows a schematic diagram of an overall structure of the embedded package structure 20, and FIG. 3b shows a cutaway drawing of the embedded package structure 20. It can be learned from FIG. 3a that, the embedded package structure 20 is a plate-like structure as a whole. It can be learned with reference to the cutaway drawing along A-A shown in FIG. 3b that, the embedded package structure 20 mainly includes two parts: a substrate 21 and a fourth dielectric layer 26 respectively. They are separately described below.

First refer to FIG. 4a. FIG. 4a shows a structure of the substrate 21. The substrate 21 has a multi-layered structure in which a plurality of layers are stacked. The multi-layered structure mainly includes three dielectric layers: a first dielectric layer 211, a second dielectric layer 213a, and a third dielectric layer 213b. During specific setting, the first dielectric layer 211 has two opposite surfaces. For ease of description, the two opposite surfaces are respectively named as a first surface and a second surface. When the second dielectric layer 213a and the third dielectric layer 213b are specifically disposed, the second dielectric layer 213a covers the first surface, and the third dielectric layer 213b covers the second surface. In this case, the disposed second dielectric layer 213a and third dielectric layer 213b are disposed on two sides of the first dielectric layer 211 in an approximately symmetrical manner.

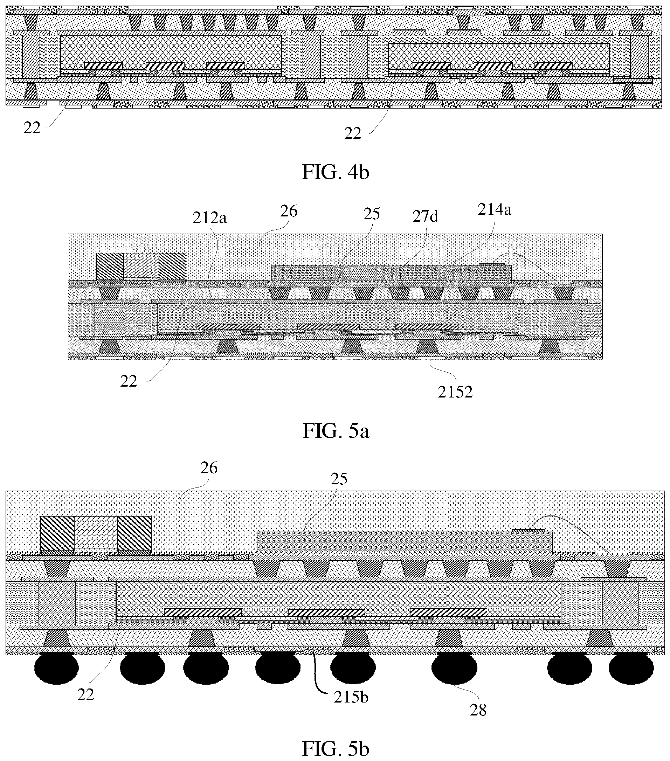

When the first dielectric layer 211 is specifically disposed, a first device 22 is embedded in the first dielectric layer 211. As shown in FIG. 4a, when the first dielectric layer 211 is disposed, the first device 22 is embedded in the first dielectric layer 211. During production, the first device 22 is placed on a carrier board, and the first dielectric layer 211 is directly formed on the carrier board through injection molding. The first dielectric layer 211 formed during injection molding wraps the first device 22, and then a thinning process is used, to make two surfaces of the first device 22 respectively exposed on the first surface and the second surface of the first device 22. When the first dielectric layer 211 is specifically prepared, the first dielectric layer 211 is prepared by using pure resin, in which no material that increases a strength such as glass fiber is doped. Because the pure resin has good fluidity, the formed first dielectric layer 211 can well surround the first device 22, and reduce generation of air bubbles or gaps, so that the first dielectric layer 211 can be well attached to the first device 22. It should be understood that, FIG. 4a shows a specific schematic structural diagram in which one first device 22 is embedded in the first dielectric layer 211. However, in this embodiment of this application, a quantity of first devices 22 embedded in the first dielectric layer 211 is not limited to one, or may be two or three. As shown in FIG. 4b, two first devices 22 are embedded in the first dielectric layer 211. However, regardless of the quantity of the first devices 22 embedded in the first dielectric layer 211, a manner of connecting the first device 22 to another structural layer is the same. Therefore, the following provides description by using an example in which one first device 22 is embedded in the first dielectric layer 211.

Still refer to FIG. 4a. It can be learned from the foregoing description that, the two opposite surfaces of the first device 22 embedded in the first dielectric layer 211 are respectively exposed on the first surface and the second surface of the first dielectric layer 211. In addition, a difference between a thickness of the first device 22 and a thickness of the first dielectric layer 211 is within a specified range, which is 0 microns to 50 microns. That is, the difference between the thickness of the first device 22 and the thickness of the first dielectric layer 211 is a difference such as 0 microns, 10 microns, 20 microns, 30 microns, 40 microns, 50 microns, or another different difference. For example, the thickness of the first dielectric layer 211 is greater than that of the first device 22, or the thickness of the first dielectric layer 211 is equal to that of the first device 22. That the thickness of the first dielectric layer 211 is equal to that of the first device 22 means that the thickness of the first dielectric layer 211 is the same as that of the first device 22 within a tolerance range. The tolerance range is ±20 microns.

For ease of description, two surfaces of a die that are exposed on the first surface and the second surface are respectively named as a third surface and a fourth surface. Using a placement direction of the substrate 21 shown in FIG. 4a as a reference direction, the first surface is an upper surface of the first dielectric layer 211, the second surface is a lower surface of the first dielectric layer 211, the fourth surface is an upper surface of the first device 22, and the third surface is a lower surface of the first device 22. A pin is disposed on the third surface. As shown in FIG. 4a, when the first device 22 is embedded in the first dielectric layer 211, the fourth surface of the first device 22 is exposed on the first surface of the first dielectric layer 211, and the third surface of the first device 22 is exposed on the second surface of the first dielectric layer 211. A distance between the fourth surface and the first surface is less than or equal to 50 microns. For example, the fourth surface is higher than or lower than the first surface by different distances such as 0 microns, 10 microns, 20 microns, and 50 microns. However, it should be understood that when the first device 22 is a device that has no heat dissipation requirement, the fourth surface of the first device 22 may not be exposed on the first surface of the first dielectric layer 211.

In addition to the foregoing dielectric layers, the embedded package structure 20 further includes a first metal layer 212a and a second metal layer 212b, where the first metal layer 212a and the second metal layer 212b are respectively arranged on two opposite sides of the first device 22. Still refer to FIG. 4a. When the first metal layer 212a and the second metal layer 212b are disposed, the first metal layer 212a covers the first surface of the first dielectric layer 211 and is located between the first dielectric layer 211 and the second dielectric layer 213a. Still refer to FIG. 4a. When the first metal layer 212a is disposed, a metal layer is coated on the first surface of the first dielectric layer 211 through sputtering or by using another process, and the coated first metal layer 212a covers the exposed fourth surface of the first device 22. Then, the first metal layer 212a is etched to form different patterns, but the first metal layer 212a after etching includes at least a thermal conductive layer 2122 covering the fourth surface of the first device 22. The first metal layer 212a includes two electrically isolated parts: a conductive layer 2121 and the thermal conductive layer 2122. The thermal conductive layer 2122 is in contact with the first device 22. During preparation, metal is directly sputtered onto the first device 22. When the first device 22 is a chip, the first device 22 uses a die. In this case, the thermal conductive layer 2122 is in direct contact with the die. During heat dissipation of the die, generated heat is directly transferred to the thermal conductive layer 2122. Compared with a packaged chip used as an embedded chip in a conventional technology, the packaged chip in the conventional technology includes a circuit layer and a package layer for packaging the circuit layer. When a heat dissipation structure is disposed, a thermal conductive layer is laid at the package layer of the packaged chip and is not in direct contact with the chip, thereby increasing heat transfer paths. However, in this embodiment, the thermal conductive layer is in direct contact with the die, to improve a heat dissipation effect. In addition, in this embodiment of this application, an area of the thermal conductive layer 2122 is greater than that of a surface of the first device 22. That is, the area of the thermal conductive layer 2122 is greater than that of the fourth surface of the first device 22, thereby further improving the heat dissipation effect of the first device 22.

When the second dielectric layer 213a is prepared, the second dielectric layer 213a is directly prepared at the first metal layer 212a, and the prepared second dielectric layer 213a has a particular strength. The second dielectric layer 213a is prepared by using a resin material doped with glass fiber, provided that a ratio of the glass fiber to resin is a common ratio in the conventional technology. It needs to be ensured that the second dielectric layer 213a has a particular supporting strength.

Still refer to FIG. 4a. When the second dielectric layer 213a is prepared, a plurality of thermal holes 27d are provided in the second dielectric layer 213a. After the second dielectric layer 213a is formed, the plurality of thermal holes 27d are formed in the second dielectric layer 213a through etching or by using another process. A vertical projection of each thermal hole 27d on the first surface is located at the thermal conductive layer 2122, and each thermal hole 27d is enabled to communicate with the thermal conductive layer 2122, so that heat absorbed by the thermal conductive layer 2122 is transferred by using the thermal hole 27d. In addition, locations and an arrangement manner of the thermal holes 27d may be determined based on requirements and are not limited to the manner shown in FIG. 4a.

Still refer to FIG. 4a. When the second metal layer 212b is disposed, the second metal layer 212b is a first circuit layer. During setting, a metal layer is first formed on the second surface of the first dielectric layer 211 through sputtering or by using another process, and then a required circuit pattern is formed through etching. In addition, when the second metal layer 212b is disposed, the second metal layer 212b is electrically connected to the first device 22. As shown in FIG. 4a, there is a protective film layer on the third surface of the first device 22, and the protective film layer has a window. The pin of the first device 22 is exposed outside the window of the protective film layer. When the second metal layer 212b is sputtered on the second surface, conductive metal fills the window of the protective film layer and is electrically connected to the pin of the first device 22, to implement an electrical connection between the first device 22 and the second metal layer 212b. However, when the window is opened in the protective layer, due to limitation of a process level, the opened window has a diameter of approximately 40 µm, resulting in a relatively large size of a connection between the second metal layer 212b and the pin. Therefore, when the connection between the second metal layer 212b and the first device 22 needs to be relatively small, the manner shown in FIG. 4a may be used: A photosensitive resin layer 221 may be preset outside the protective film layer of the first device 22, and the photosensitive resin layer 221 is directly connected to a region opposite to the pin of the first device 22. This may be understood as opening a window in the protective film layer, then preparing the photosensitive resin layer 221 at the protective film layer, and filling the disposed photosensitive resin layer 221 into the window for a direct connection to the pin. When the second metal layer 212b needs to be connected to the pin, a window with a diameter less than 5 µm to 10 µm may be opened in the photosensitive resin layer 221 by using a process for preparing a wafer (the wafer is a source material of the first device 22) when the first device 22 is produced. Therefore, an aperture of the connection between the second metal layer 212b and the pin is reduced, so that pins of the first device 22 can be disposed more densely, thereby facilitating miniaturization of the entire first device 22. Certainly, the foregoing description is provided by using an example in which the window is a circle. However, the window opened in this embodiment of this application is not limited to a circle, but may also have different sizes such as a square and an oval.

Still refer to the structure in FIG. 4a. When the second metal layer 212b is disposed, the second metal layer 212b is located between the first dielectric layer 211 and the third dielectric layer 213b. After the second metal layer 212b is prepared, the third dielectric layer 213b may be directly prepared at the second metal layer 212b, and the prepared third dielectric layer 213b covers the second metal layer 212b. A material of the third dielectric layer 213b is the same as that of the second dielectric layer 213a. The third dielectric layer 213b is also prepared by using a resin material doped with glass fiber. In addition, when the second dielectric layer 213a and the third dielectric layer 213b are disposed, a thickness of the second dielectric layer 213a is approximately the same or completely the same as that of the third dielectric layer 213b. In addition, first vias 27a for connecting to the second metal layer 212b are provided in the third dielectric layer 213b. As shown in FIG. 4a, there are a plurality of connecting ends 2123 at the second metal layer 212b, and one first via 27a is correspondingly provided in each of the connecting ends 2123. One end of the first via 27a is electrically connected to the connecting end 2123 at the second metal layer 212b, and the other end is configured to connect to another circuit, so that the second metal layer 212b is connected to the another circuit. When the first vias 27a are specifically provided, positions of the first vias 27a are set based on positions of the connecting ends 2123 at the second metal layer 212b. When the first vias 27a are formed, through holes are provided in the second dielectric layer 213a through etching or in another known manner, and then metal layers are evaporated on side walls of the through holes. The metal layers are one-to-one electrically connected to the connecting ends 2123 of the second metal layer 212b.

It can be learned from the foregoing description that the placement direction of the embedded package structure 20 shown in FIG. 4a is used as the reference direction. In a vertical direction, metal layers (the first metal layer 212a and the second metal layer 212b) are first respectively disposed on upper and lower sides of the first dielectric layer 211, and then two dielectric layers (the second dielectric layer 213a and the third dielectric layer 213b) are correspondingly disposed respectively. When the two metal layers are disposed, the two metal layers use a same material, such as copper, silver, or another conductive metal. For example, the two metal layers both use a copper material. A copper doping ratio of the first metal layer 212a is the same as or approximate to that of the second metal layer 212b, where the copper doping ratio is a ratio of a metal covered area to a total area of a surface to which metal is sputtered. Therefore, when the copper doping ratio of the first metal layer 212a is approximately equal to that of the second metal layer 212b, expansion coefficients of the first metal layer 212a and the second metal layer 212b located on the two sides of the first dielectric layer 211 are the same. For the disposed second dielectric layer 213a and third dielectric layer 213b, because the second dielectric layer 213a and the third dielectric layer 213b use the same material and also have the approximately same thicknesses, expansion coefficients of the two disposed dielectric layers are also approximately the same. It can be learned from the foregoing description that, approximate structures are symmetrically disposed on the two sides (up and down directions) of the first dielectric layer 211, to form a quasi-symmetrical structure (the first metal layer 212a is quasi-symmetrical with the second metal layer 212b, and the second dielectric layer 213a is quasi-symmetrical with the third dielectric layer 213b), so that expansion coefficients of the structures located on the two sides of the first dielectric layer 211 are approximate to each other. Therefore, when the embedded package structure 20 is used, deformations of the structures on the two sides of the first dielectric layer 211 are approximately equal, so that warpage of the embedded package structure 20 can be effectively limited, and a use effect of the substrate 21 is improved. The foregoing quasi-symmetry refers to a case in which positions of the two structures are symmetrical, and a difference between the two structures is not large. Using the first metal layer 212a and the second metal layer 212b as an example, when the copper doping ratio of the first metal layer 212a is approximately equal to that of the second metal layer 212b, it is considered that the first metal layer 212a and the second metal layer 212b are disposed on the two sides of the first dielectric layer 211 in a quasi-symmetric manner.

Still refer to FIG. 4a. In addition to the foregoing quasi-symmetrical structures, another quasi-symmetrical structure is further disposed in the embedded package structure 20. For example, the embedded package structure 20 further includes a third metal layer 214b and a fourth metal layer 214a. The third metal layer 214b is disposed on a surface of the third dielectric layer 213b facing away from the first dielectric layer 211, and the fourth metal layer 214a is disposed on a surface of the second dielectric layer 213a facing away from the first dielectric layer 211. When the third metal layer 214b and the fourth metal layer 214a are specifically disposed, the third metal layer 214b and the fourth metal layer 214a are both circuit layers. The third metal layer 214b is a second circuit layer, and the fourth metal layer 214a is a third circuit layer. First, when the third metal layer 214b is prepared, a metal layer is formed on the surface of the third dielectric layer 213b facing away from the first dielectric layer 211 through sputtering or by using another known process, and then the third metal layer 214b is formed through etching or laser cutting. As shown in FIG. 4a, when the third metal layer 214b is formed, the third metal layer 214b is electrically connected to the second metal layer 212b. When an electrical connection is specifically implemented, the third metal layer 214b has connecting ends 2141 configured to connect to the second metal layer 212b, and the connecting ends 2141 are one-to-one connected to the first vias 27a. It can be learned from FIG. 4a that, the second metal layer 212b and the third metal layer 214b are respectively located on two ends of the first vias 27a, and the second metal layer 212b and the third metal layer 214b are electrically connected to each other by using the provided first vias 27a. In addition, two ends of each first via 27a are respectively connected to the connecting end 2123 of the second metal layer 212b and the connecting end 2141 of the third metal layer 214b, so that the first metal layer 212a is conductively connected to the third metal layer 214b.

For the fourth metal layer 214a, as shown in FIG. 4a, the fourth metal layer 214a is disposed on the surface of the second dielectric layer 213a facing away from the first dielectric layer 211. When the fourth metal layer 214a is prepared, a metal layer is formed on the surface of the second dielectric layer 213a facing away from the first dielectric layer 211 through sputtering or by using another known process, then the third circuit layer is formed through etching or laser cutting, and the formed fourth metal layer 214a is also used as a heat dissipation structure of the first device 22. As shown in FIG. 4a, when the fourth metal layer 214a is disposed, the fourth metal layer 214a covers the thermal holes 27d. Heat dissipated from the top of the first device 22 is transferred to the thermal holes 27d by using the thermal conductive layer 2122. Then, the heat is transferred to the fourth metal layer 214a by using the thermal holes 27d, so that the heat dissipated from the top of the first device 22 can be dissipated by using the first metal layer 212a and the fourth metal layer 214a, thereby improving the heat dissipation effect.

Still refer to FIG. 3b. It can be learned from FIG. 3b that when the third metal layer 214b and the fourth metal layer 214a are specifically disposed, the third metal layer 214b and the fourth metal layer 214a are respectively arranged on the two sides of the first dielectric layer 211, and the third metal layer 214b and the fourth metal layer 214a are both circuit layers. However, when the third metal layer 214b and the fourth metal layer 214a are disposed, a manner of disposing the third metal layer 214b and the fourth metal layer 214a is similar to that of disposing the first metal layer 212a and the second metal layer 212b. That is, a copper doping ratio of the third metal layer 214b is approximate to that of the fourth metal layer 214a, so that the third metal layer 214b and the fourth metal layer 214a are disposed on the two sides of the first dielectric layer 211 in a quasi-symmetrical manner. Therefore, the disposed third metal layer 214b and fourth metal layer 214a do not cause warpage of the embedded package structure 20.

In addition, when the third metal layer 214b and the fourth metal layer 214a are disposed, the third metal layer 214b and the fourth metal layer 214a are respectively the second circuit layer and the third circuit layer, and the disposed third metal layer 214b is electrically connected to the second metal layer 212b. When the fourth metal layer 214a is specifically disposed, based on requirements, the fourth metal layer 214a may be separately electrically connected to the third metal layer 214b and the second metal layer 212b, or may be electrically connected to only the third metal layer 214b, or may be electrically connected to only the second metal layer 212b, or the like. As shown in FIG. 4a, the fourth metal layer 214a is separately electrically connected to the third metal layer 214b and the second metal layer 212b. First, a connection between the fourth metal layer 214a and the second metal layer 212b is described. As shown in FIG. 4a, when the fourth metal layer 214a is electrically connected to the second metal layer 212b, because the fourth metal layer 214a and the second metal layer 212b are respectively arranged on two sides of the first device 22 and are not adjacent to each other, during disposal, a structure running through the first dielectric layer 211 and the second dielectric layer 213a needs to be disposed to connect the second metal layer 212b to the fourth metal layer 214a. The foregoing structure includes a conductive pillar 23 embedded in the first dielectric layer 211 and a second via 27c provided in the second dielectric layer 213a, where the second via 27c is electrically connected to the conductive pillar 23. Still refer to FIG. 4a. During specific implementation, at least one through hole is provided in the first dielectric layer 211 (the through hole is not marked in the figure because the through hole overlaps the conductive pillar 23), and a conductive pillar 23 is fixed in each through hole. However, during formation of the foregoing structure, when the first dielectric layer 211 is prepared, the first device 22 and the conductive pillar 23 are first placed at preset positions, and then the first dielectric layer 211 is formed through injection molding of resin. After injection molding, the conductive pillar 23 is embedded in the first dielectric layer 211. Two surfaces of the conductive pillar 23 are respectively exposed on the first surface and the second surface of the first dielectric layer 211. It can be learned from the foregoing description that after the first dielectric layer 211 is prepared, the first metal layer 212a needs to be prepared on the first surface and the second metal layer 212b needs to be prepared on the second surface. When the first metal layer 212a and the second metal layer 212b are prepared, the first metal layer 212a and the second metal layer 212b are respectively electrically connected to the two exposed surfaces of the conductive pillar 23. When the second metal layer 212b is formed through etching or by using another process, the conductive pillar 23 is directly electrically connected to the second metal layer 212b. When the first metal layer 212a is etched, in addition to the thermal conductive layer 2122, the first metal layer 212a also forms the conductive layer 2121 connected to the conductive pillar 23. When the second dielectric layer 213a continues to be prepared, after the second dielectric layer 213a is formed, a hole is provided in the second dielectric layer 213a, so that the conductive layer 2121 is exposed, and then a metal layer is coated in the hole to form the second via 27c. The second via 27c is electrically connected to the conductive pillar 23 by using the conductive layer 2121. When the fourth metal layer 214a is formed on the surface of the second dielectric layer 213a facing away from the first dielectric layer 211, the fourth metal layer 214a is electrically connected to the second via 27c. In this case, the fourth metal layer 214a is electrically connected to the second metal layer 212b by using the second via 27c and the conductive pillar 23. It should be understood that, when the second via 27c and the conductive pillar 23 are specifically disposed, different quantities of second vias 27c and conductive pillars 23 may be disposed based on requirements. As shown in FIG. 4a, there are two conductive pillars 23, but FIG. 4a is only an example. In this embodiment of this application, different quantities of conductive pillars 23, for example, three, one, five, or six conductive pillars 23, may be disposed based on requirements, provided that it is ensured that the fourth metal layer 214a can be connected to the second metal layer 212b.

Still referring to FIG. 4a. When the fourth metal layer 214a is electrically connected to the second circuit layer, when the fourth metal layer 214a is electrically connected to the third metal layer 214b, the foregoing structure of the second via 27c and the conductive pillar 23 is also used. However, because the third dielectric layer 213b is further disposed between the conductive pillar 23 and the third metal layer 214b, a third via 27b is provided in the disposed third dielectric layer 213b, to connect the conductive pillar 23 to the third metal layer 214b. For a manner of providing the third via 27b, refer to the foregoing manner of providing the second via 27c. In addition, the third via 27b is also electrically connected to the conductive pillar 23. In this case, when the fourth metal layer 214a is electrically connected to the third metal layer 214b, the second via 27c, the conductive pillar 23, and the third via 27b are specifically used.

Still refer to FIG. 4a. In the entire substrate 21, outermost layers are the third metal layer 214b and the fourth metal layer 214a. In addition, to protect the third metal layer 214b and the fourth metal layer 214a, protective layers are respectively covered on the third metal layer 214b and the fourth metal layer 214a. The protective layer may be a solder mask layer, or different layers with a protective function such as a plastic package layer or a resin layer. However, to ensure that the substrate 21 can be electrically connected to another component, a window is opened in the disposed protective layer. For ease of understanding, the following separately provides description.

First, for the second circuit layer, for ease of description, the protective layer covering the third metal layer 214b is named as a first protective layer 215b. When the first protective layer 215b is specifically disposed, a protective layer is formed at the second circuit layer through injection molding or evaporation, and the formed first protective layer 215b has a plurality of first windows 2152. The first windows 2152 correspond to the connecting ends 2141 of the third metal layer 214b. In this case, the third metal layer 214b has first connecting ends exposed on the first windows 2152. The disposed first connecting ends may be configured to connect to another circuit. As shown in FIG. 5a, the first windows 2152 formed in this case may implement an electrical connection between the embedded package structure 20 and the mainboard by using an LGA (land grid array). In addition to the foregoing manner, another manner may also be used. As shown in FIG. 5b, in this case, the substrate 21 further includes a first protective layer 215b covering the third metal layer 214b, the first protective layer 215b has a plurality of first windows, and solder balls 28 connected to the second circuit layer are disposed at the first windows. The solder balls 28 can implement an electrical connection between the substrate 21 and the mainboard by using a BGA (ball 28 grid array). Refer to both FIG. 2a and FIG. 2b. During a specific connection, the substrate 21 is electrically connected to the mainboard 30 by using the LGA (land grid array) or the BGA (ball grid array).

In addition, the third metal layer 214b and the second metal layer 212b may also be used as a heat dissipation channel of the first device 22 in addition to being used for the electrical connection. When heat dissipation of the first device 22 is implemented by using the mainboard 30, it can be learned from FIG. 4a that, when heat is transferred, the heat generated by the first device 22 is transferred to the second metal layer 212b, and then transferred to the third metal layer 214b by using the second metal layer 212b, and then transferred to the mainboard. In addition, it can be learned from the foregoing description that, when the second metal layer 212b is disposed, the second metal layer 212b is directly attached to the first device 22, and there is a relatively large contact area between the second metal layer 212b and the first device 22. Therefore, the heat generated by the first device 22 can be quickly transferred to the second metal layer 212b, and transferred to the third metal layer 214b by using the second metal layer 212b. The heat generated by the first device 22 is transferred by using the two metal layers, to facilitate heat dissipation of the first device 22. In addition, for the first device 22, a chip with relatively high power consumption, such as a radio frequency drive chip, may be used. When a chip with relatively high radio frequency is used, if the chip is embedded in the first dielectric layer 211, compared with a state in which the chip is disposed on a surface of the substrate 21 (a surface of the substrate 21 facing away from the mainboard 30), when the mainboard 30 is used as a heat dissipation path, the embedding setting manner enables the chip to be closer to the mainboard 30, thereby reducing a length of the chip heat dissipation path, and facilitating heat dissipation of the chip. In addition, by embedding the chip in the first medium, an area of the surface that is of the substrate 21 (the surface of the substrate 21 facing away from the mainboard 30) and that is occupied by the chip can be reduced, thereby helping dispose more devices.

Still refer to the structure shown in FIG. 4a. For the fourth metal layer 214a, a protective layer covering the fourth metal layer 214a is further included. The protective layer is named as a second protective layer 215a. The second protective layer 215a has a plurality of second windows 2151. The third circuit has second connecting ends exposed on the second windows 2151. A structure of the second protective layer 215a is approximately the same as that of the first protective layer 215b. Therefore, reference may be made to the foregoing description about the first protective layer 215b. Also refer to the structure shown in FIG. 2b. Another device, for example, a second device 25 or another passive device 24, may be disposed on the surface of the substrate 21, and the second device 25 and the passive device 24 are connected to the first circuit layer. In FIG. 2b, one second device 25 and one passive device 24 are disposed. The passive device 24 may be a passive device 24, such as an inductor, a capacitor, or a resistor, used for functions such as filtering. The second device 25 is a radio frequency device, such as a power amplifier or a filter, that implements interconnection by using an Au wire bonding process or a flip-chip bonding process. In addition, the embedded package structure 20 further includes the fourth dielectric layer 26 disposed at the second dielectric layer 213a and covering the second device 25 and the passive device 24. The fourth dielectric layer 26 is used as a package layer, and a specific material of the fourth dielectric layer 26 may be resin. When the second device 25 and the passive device 24 are specifically packaged, liquid resin is poured onto the second device 25 and the passive device 24, and after cooling, the second device 25 and the passive device 24 are embedded in the fourth dielectric layer 26. When the second device 25 and the passive device 24 need to be shielded, a shielding cover (not shown in the figure) may further be covered at the fourth dielectric layer 26. The shielding cover is made of a metal material and is electrically connected to a ground cable of any circuit layer in the substrate 21, to shield the second device 25 and the passive device 24.

Still refer to FIG. 5a. When heat dissipation is performed by using the top, a heat-sink device may be disposed at the fourth dielectric layer 26 (the heat-sink device is not shown in FIG. 5a), to perform heat dissipation on the entire embedded package structure. In this case, the heat generated by the embedded first device 22 may be transferred to the thermal holes 27d by using the first metal layer 212a, and then transferred to the fourth metal layer 214a by using the thermal holes 27d. In this way, the heat dissipated from the top of the first device 22 can be dissipated to the surface of the substrate 21 by using the thermal conductive layer 2122 and the fourth metal layer 214a, and heat dissipation is performed by using the heat-sink device.

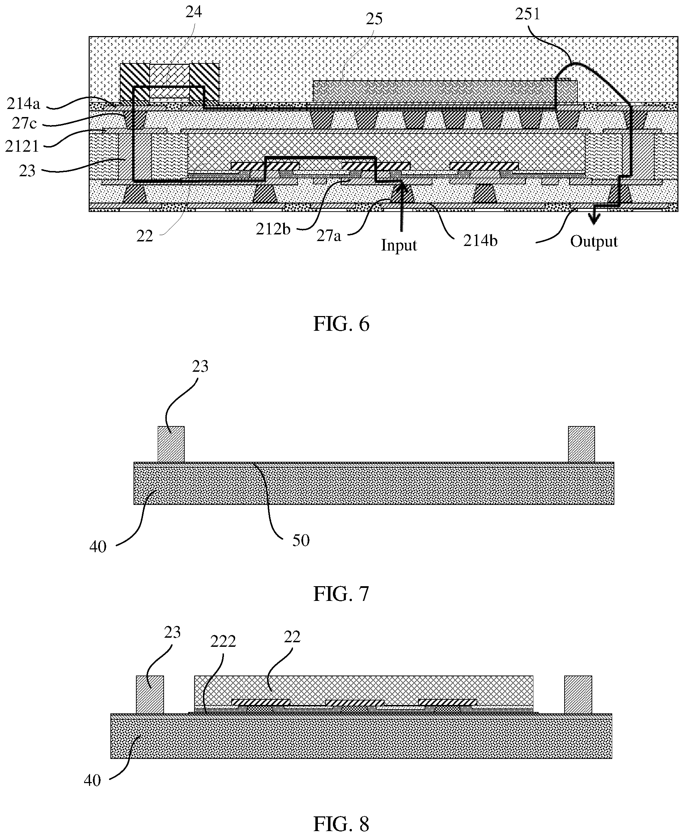

Also refer to FIG. 6. During a specific connection, when connections between devices in the substrate 21 and connections between devices outside the substrate 21 are specifically implemented, another device on the mainboard 30 receives a signal. The signal is transmitted into the third metal layer 214b by using interconnected pads between the embedded package structure 20 and the mainboard 30. The signal is, for example, input shown in FIG. 6. After the signal enters the substrate 21, the signal is transmitted to the second metal layer 212b by using the first vias 27a, and then the signal is transmitted by using the second metal layer 212b to the first device 22 for processing. The processed signal passes through an output terminal of the first device 22 to the second metal layer 212b, and then is transmitted into the passive device 24 by using the conductive pillar 23, the conductive layer 2121, the second via 27c, the fourth metal layer 214a, and a pad and a solder for soldering the passive device 24. After filtering, denoising, and other processing are performed on the signal, the signal is transmitted from the passive device 24 by using the fourth metal layer 214a to a power amplifier (the second device 25) for signal enhancement. Finally, the signal (output) is transmitted onto the mainboard by using a metal jumper wire 251, the fourth metal layer 214a, the second via 27c, the conductive layer 2121, the conductive pillar 23, the second metal layer 212b, the first vias 27a, the third metal layer 214b, and the pads. Processing of the entire signal is implemented. Specifically, reference may be made to a path shown by a solid line with an arrow in FIG. 6, where the path is a path of the signal in the embedded package structure 20.

To facilitate understanding of the embedded package structure provided in this embodiment of this application, an embodiment of this application further provides a method for preparing a package substrate 21. The method specifically includes:
preparing a first dielectric layer 211 around a first device 22, the first device 22 being embedded in the prepared first dielectric layer 211, two opposite surfaces of the first device 22 being respectively exposed on a first surface and a second surface that are opposite to each other of the first dielectric layer 211, and a difference between a thickness of the first device 22 and a thickness of the first dielectric layer 211 being within a specified range;
attaching a thermal conductive layer 2122 to the first surface, where the thermal conductive layer is in contact with the first device;
preparing a second dielectric layer 213a at the thermal conductive layer 2122;
preparing at least one thermal hole 27d in the second dielectric layer 213a, where the at least one thermal hole 27d is connected to the thermal conductive layer;
preparing, on a surface of the first device 22 that is exposed on the second surface, a first circuit layer connected to the first device 22;
preparing a third dielectric layer 213b at the first circuit layer; and
preparing, in the third dielectric layer 213b, a first via 27a connected to the first circuit layer.

An expansion coefficient of the thermal conductive layer 2122 is the same as that of the first circuit layer, and an expansion coefficient of the second dielectric layer is the same as that of the third dielectric layer.

In addition to the foregoing steps, the method further includes: preparing a second circuit layer on a surface of the third dielectric layer 213b facing away from the first dielectric layer 211, where the second circuit layer is electrically connected to the first circuit layer through the first via 27a;
preparing a third circuit layer on a surface of the second dielectric layer 213a facing away from the first dielectric layer 211; and
electrically connecting the third circuit layer to the first circuit layer.

An expansion coefficient of the second circuit layer is the same as that of the third circuit layer.

In addition, the method further includes: the preparing a first dielectric layer 211 around a first device 22, the first device 22 being embedded in the prepared first dielectric layer 211, two opposite surfaces of the first device 22 being respectively exposed on a first surface and a second surface that are opposite to each other of the first dielectric layer 211 is specifically: disposing a copper foil layer on a carrier board; placing the first device 22 at the copper foil layer; forming a dielectric layer at the copper foil layer through injection molding, to wrap the first device 22; and thinning the dielectric layer to form the first dielectric layer 211.

The electrically connecting the third circuit layer to the first circuit layer is specifically:
preparing a conductive pillar 23 at the copper foil layer;
wrapping, by the dielectric layer, the conductive pillar 23 when the dielectric layer is formed through injection molding;
the conductive pillar 23 being exposed when the dielectric layer is thinned to form the first dielectric layer 211;
when the second dielectric layer 213a is prepared, providing a second via electrically connected to the conductive pillar 23;
the second circuit layer being electrically connected to the second via when the second circuit layer is disposed;
de-bonding the first dielectric layer 211 from the copper foil layer;
preparing a third via when the third dielectric layer 213b is prepared, where the third via is electrically connected to the conductive pillar 23; and
electrically connecting the third circuit layer to the third via when the third circuit layer is prepared.

For ease of understanding of the foregoing method steps, the following describes the method steps in detail with reference to specific accompanying drawings.

Step 1: Form the conductive pillar 23 on the carrier board 40.

Specifically, as shown in FIG. 7, the conductive pillar 23 is processed and manufactured at the copper foil layer 50 of the debondable carrier board 40 based on a thickness of the first device. The conductive pillar 23 is required to have a thickness same as that of the first device. The following specific detailed steps are included: process steps such as pretreatment before film pasting, film pasting, exposure, development, pattern plating, acid washing, and stripping for forming the conductive pillar 23. The foregoing manufacturing processes are all common processes in a conventional technology. Therefore, details are not described herein.

Step 2: Perform surface mounting on the first device 22.

Specifically, as shown in FIG. 8, a front surface (the third surface 222) that is of the first device 22 and on which a window is pre-opened and a surface-mount adhesive film is pre-manufactured is mounted downwardly to the copper foil of the carrier board 40. Moreover, the surface-mount process requires relatively high precision to ensure alignment process precision required by lines that need to be interconnected.

Step 3: Perform plastic packaging or embedded lamination.

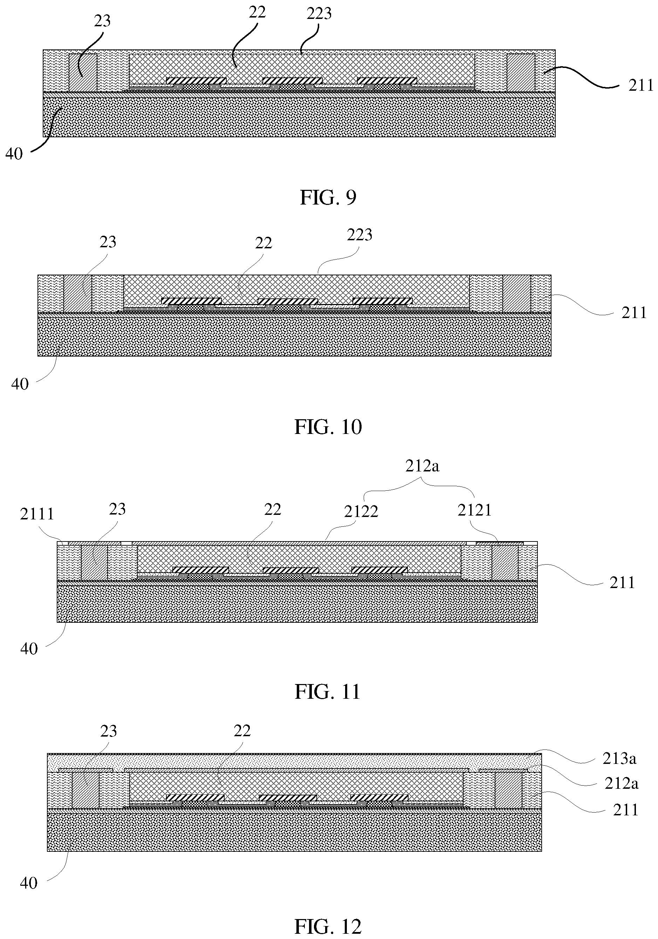

Specifically, as shown in FIG. 9, the first device 22 and the conductive pillar 23 may be completely embedded by using resin (doped with no glass fiber) in a manner of plastic packaging or a manner of vacuum lamination process.

Step 4: Perform thinning.

Specifically, as shown in FIG. 10, a process manner such as mechanical thinning, plasma thinning, or laser thinning, or a hybrid process manner is used to clean the resin on a surface of the conductive pillar 23 and a back surface (the fourth surface 223) of the first device 22, to expose the conductive pillar 23 and the fourth surface 223 of the first device 22. A thinned resin layer is the first dielectric layer 211.

Step 5: Manufacture inner-layer lines, to form a first metal layer 212a.

Specifically, as shown in FIG. 11, an adhesion layer and a metal thin film are first processed in manners such as PVD and evaporation in a plane (the first surface 2111) in which the first dielectric layer 211 is thinned, and then the detailed process procedures such as pretreatment before film pasting, film pasting, exposure, development, pattern plating, acid washing, and stripping are repeated, to manufacture a line layer on the back surface of the first device 22, to form the first metal layer 212a. In addition, the first metal layer 212a includes a conductive layer 2121 connected to the conductive pillar 23 and the thermal conductive layer 2122 for performing heat dissipation for the first device 22.

Step 6: Prepare the second dielectric layer 213a through lamination.

Specifically, as shown in FIG. 12, the second dielectric layer 213a is manufactured on a back metal layer through high-temperature or vacuum lamination, and the manufactured second dielectric layer 213a uses resin doped with glass fiber.

Step 7: Perform de-bonding.

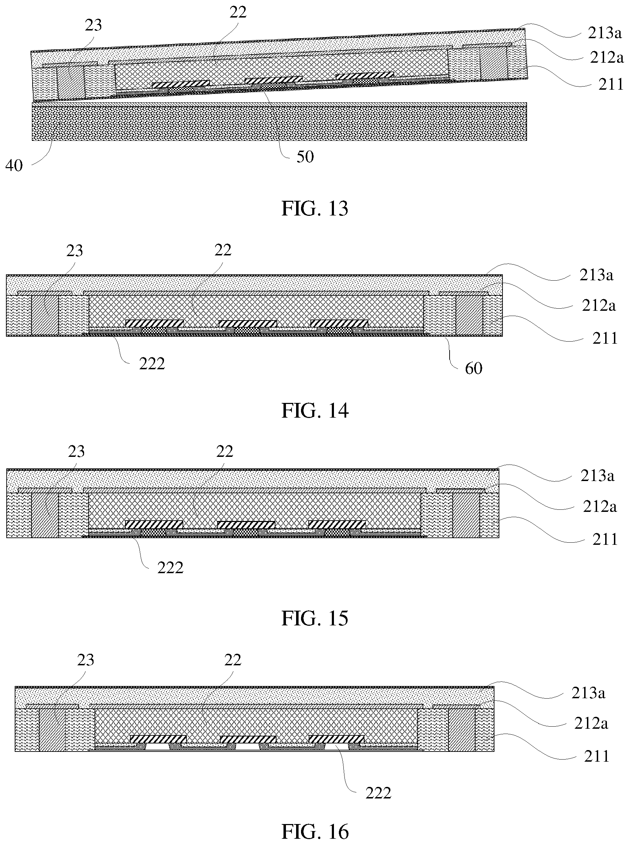

Specifically, as shown in FIG. 13 and FIG. 14, the structure formed above is directly separated from the carrier board 40 by using debondability of the copper foil layer 50 on the carrier board 40. As shown in FIG. 14, the substrate 21 in which the first device 22 is embedded is formed after de-bonding.

Step 8: Etch copper.

Specifically, as shown in FIG. 14 and FIG. 15, the copper foil layer 50 adhered to the third surface 222 of the first device 22 is removed by using an etching process, to expose the first dielectric layer 211 and the first device 22.

Step 9: Remove the surface-mount adhesive film.

Specifically, as shown in FIG. 16, the surface-mount adhesive film pre-manufactured on the front surface of the first device 22 is removed by using a chemical liquid wet process, and residual adhesive is removed by using a plasma cleaning device to expose a pin 222 of the first device 22.

Step 10: Prepare a second metal layer 212b, and form the first circuit layer.

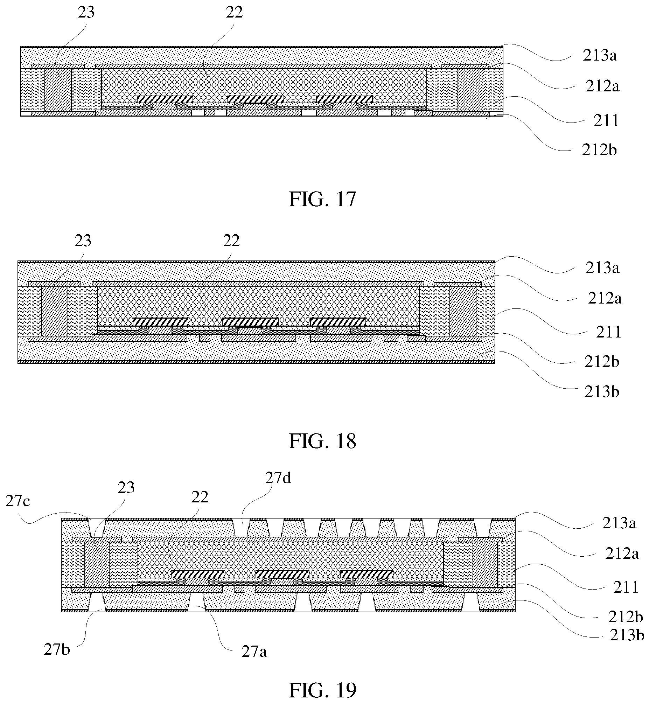

Specifically, as shown in FIG. 17, an adhesion layer and a metal thin film are processed in manners such as PVD and evaporation on the window in the front surface of the first device 22 and resin on the surface of the first device 22, to form the second metal layer 212b, and then the detailed process procedures such as pretreatment before film pasting, film pasting, exposure, development, pattern plating, acid washing, and stripping are repeated, to manufacture an interconnected line layer on the front surface of the first device, to form the first circuit layer.

Step 11: Perform lamination to prepare the third dielectric layer 213b.

Specifically, as shown in FIG. 18, a layer of dielectric layer resin (the third dielectric layer 213b) with a thickness same as that of the second dielectric layer 213a is manufactured at the second metal layer 212b by using a high-temperature or vacuum lamination process method, to form a symmetrical structure.

Step 12: Manufacture laser blind holes and outer-layer lines.

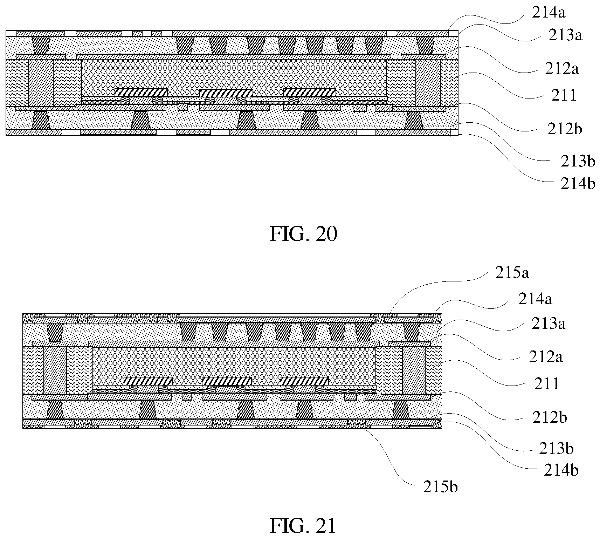

Specifically, as shown in FIG. 19, vias are processed in a laser drilling manner on pads corresponding to the inner-layer lines, and after the vias (a first via 27a, a second via 27c, a third via 27b, and a thermal hole 27d) are manufactured, as shown in FIG. 20, the detailed process procedures such as pretreatment before film pasting, film pasting, exposure, development, pattern plating, acid washing, and stripping are repeated to manufacture the outer-layer lines, specifically a third metal layer 214b and a fourth metal layer 214a.

Step 13: Perform solder masking and surface metal processing.

Specifically, as shown in FIG. 21, a solder mask layer is manufactured on the outer-layer lines by using a vacuum lamination process method, to form a first protective layer 215b and a second protective layer 215a, and windows are opened at positions at which pins are correspondingly led out, to form pads interconnected with the outside, and a metal layer or an organic thin film layer is manufactured on the pads, to prevent oxidation of outer-layer copper pads and exposed lines.

It can be learned from the foregoing steps that the embedded package structure prepared and formed by using the foregoing method alleviates warpage of the substrate in a quasi-symmetrical manner, and heat dissipation of the first device 22 is facilitated by using the plurality of disposed metal layers.

As shown in FIG. 2a, an embodiment of this application further provides a terminal. The terminal may be a common terminal such as a mobile phone or a tablet computer. The terminal includes the foregoing embedded package structure. The embedded package structure alleviates warpage of the substrate in a quasi-symmetrical manner, and heat dissipation of the first device is facilitated by using the plurality of disposed metal layers.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An embedded package structure, comprising:
a first dielectric layer, wherein the first dielectric layer comprises a first surface and a second surface that are disposed opposite to each other;
a first device embedded in the first dielectric layer, wherein a difference between a thickness of the first device and a thickness of the first dielectric layer is within a specified range;
a thermal conductive layer, disposed on the first surface, wherein the thermal conductive layer is in contact with the first device;
a first circuit layer, disposed on the second surface of the first dielectric layer, wherein the first circuit layer is electrically connected to the first device;
a second dielectric layer, covering the thermal conductive layer, wherein at least one thermal hole connected to the thermal conductive layer is provided in the second dielectric layer; and
a third dielectric layer, covering the first circuit layer, wherein a first via connected to the first circuit layer is provided in the third dielectric layer.

2. The embedded package structure according to claim 1, wherein the thickness of the first device is equal to that of the first dielectric layer.

3. The embedded package structure according to claim 1 or 2, wherein a thickness of the second dielectric layer is equal to that of the third dielectric layer.

4. The embedded package structure according to any one of claims 1 to 3, wherein
a second circuit layer is disposed on a surface of the third dielectric layer facing away from the first dielectric layer, and the second circuit layer is electrically connected to the first circuit layer through the first via; and
a third circuit layer is disposed on a surface of the second dielectric layer facing away from the first dielectric layer, and the third circuit layer is electrically connected to the first circuit layer.

5. The embedded package structure according to any one of claims 1 to 4, wherein an area in which the thermal conductive layer covers the first surface is greater than an area of a surface of the first device.

6. The embedded package structure according to any one of claims 1 to 5, wherein the specified range is 0 microns to 50 microns.

7. The embedded package structure according to any one of claims 1 to 6, further comprising a second device disposed at the second dielectric layer and a fourth dielectric layer used for embedding the second device, wherein the second device is electrically connected to the first circuit layer.

8. A terminal, comprising a housing and a mainboard disposed in the housing, and further comprising an embedded package structure disposed on the mainboard, wherein
the embedded package structure comprises:
a first dielectric layer, wherein the first dielectric layer comprises a first surface and a second surface that are disposed opposite to each other;
a first device embedded in the first dielectric layer, wherein a difference between a thickness of the first device and a thickness of the first dielectric layer is within a specified range;
a thermal conductive layer, disposed on the first surface, wherein the thermal conductive layer is in contact with the first device;
a first circuit layer, disposed on the second surface of the first dielectric layer, wherein the first circuit layer is electrically connected to the first device;
a second dielectric layer, covering the thermal conductive layer, wherein at least one thermal hole connected to the thermal conductive layer is provided in the second dielectric layer; and
a third dielectric layer, covering the first circuit layer, wherein a first via connected to the first circuit layer is provided in the third dielectric layer.

9. The terminal according to claim 8, wherein the thickness of the first chip is equal to that of the first dielectric layer.

10. The terminal according to claim 8 or 9, wherein a thickness of the second dielectric layer is equal to that of the third dielectric layer;
a second circuit layer is disposed on a surface of the third dielectric layer facing away from the first dielectric layer, and the second circuit layer is electrically connected to the first circuit layer through the first via; and
a third circuit layer is disposed on a surface of the second dielectric layer facing away from the first dielectric layer, and the third circuit layer is electrically connected to the first circuit layer.

11. The terminal according to claim 10, wherein an area in which the thermal conductive layer covers the first surface is greater than an area of a surface of the first device.

12. The terminal according to any one of claims 8 to 11, further comprising a second device disposed at the second dielectric layer, wherein the second device is electrically connected to the first circuit layer.

13. The terminal according to any one of claims 8 to 12, wherein the specified range is 0 microns to 50 microns.

14. The terminal according to claim 12, further comprising a fourth dielectric layer used for embedding the second device.

15. A method for preparing an embedded package structure, comprising the following steps:
preparing a first dielectric layer around a first device, the first device being embedded in the prepared first dielectric layer, two opposite surfaces of the first device being respectively exposed on a first surface and a second surface that are opposite to each other of the first dielectric layer, and a difference between a thickness of the first device and a thickness of the first dielectric layer being within a specified range;
attaching a thermal conductive layer to the first surface, wherein the thermal conductive layer is in contact with the first device;
preparing a second dielectric layer at the thermal conductive layer;
preparing at least one thermal hole in the second dielectric layer, wherein the at least one thermal hole is connected to the thermal conductive layer;
preparing, on the second surface, a first circuit layer connected to the first device;
preparing a third dielectric layer at the first circuit layer; and
preparing, in the third dielectric layer, a first via connected to the first circuit layer.

16. The method for preparing an embedded package structure according to claim 15, further comprising:
preparing a second circuit layer on a surface of the third dielectric layer facing away from the first dielectric layer, wherein the second circuit layer is electrically connected to the first circuit layer through the first via;
preparing a third circuit layer on a surface of the second dielectric layer facing away from the first dielectric layer; and
electrically connecting the third circuit layer to the first circuit layer.

17. The method for preparing an embedded package structure according to claim 16, wherein the preparing a first dielectric layer around a first device, the first device being embedded in the prepared first dielectric layer, two opposite surfaces of the first device being respectively exposed on a first surface and a second surface that are opposite to each other of the first dielectric layer is specifically:
disposing a copper foil layer on a carrier board;
placing the first device at the copper foil layer;
forming a dielectric layer at the copper foil layer through injection molding, to wrap the first device; and
thinning the dielectric layer to form the first dielectric layer.

18. The method for preparing an embedded package structure according to claim 17, wherein the electrically connecting the third circuit layer to the first circuit layer is specifically:
preparing a conductive pillar at the copper foil layer;
wrapping, by the dielectric layer, the conductive pillar when the dielectric layer is formed at the copper foil layer through injection molding;
the conductive pillar being exposed when the dielectric layer is thinned to form the first dielectric layer;
when the second dielectric layer is prepared, providing a second via electrically connected to the conductive pillar;
the second circuit layer being electrically connected to the second via when the second circuit layer is disposed;
de-bonding the first dielectric layer from the copper foil layer;
preparing a third via when the third dielectric layer is prepared, wherein the third via is electrically connected to the conductive pillar; and
electrically connecting the third circuit layer to the third via when the third circuit layer is prepared.

19. The method for preparing an embedded package structure according to claim 15, wherein an area in which the thermal conductive layer covers the first surface is greater than an area of a surface of the first device.
